# EUROPEAN PATENT SPECIFICATION

(11) **EP 2 523 026 B1**
(45) Date of publication and mention of the grant of the patent: **27.04.2016**
(21) Application number: 12167332.1
(22) Date of filing: 09.05.2012
(51) Int. Cl.: G02B 6/12, G02B 6/13, H01L 31/105

(54) **Co-integration of photonic devices on a silicon photonics platform**
Co-Integration photonischer Vorrichtungen in einer photonischen Siliziumplattform
Co-intégration de dispositifs photoniques sur une plate-forme photonique en silicium

(30) Priority: 09.05.2011 US 201161484064 P
(43) Date of publication of application: 14.11.2012
(73) Proprietor: IMEC, 3001 Leuven (BE); Universiteit Gent, 9000 Gent (BE)
(72) Inventor: Bogaerts, Wim, 9090 Melle (BE); Van Campenhout, Joris, 1850 Grimbergen (BE); Verheyen, Peter, 3001 Leuven (BE); Absil, Philippe, 3001 Leuven (BE)
(74) Representative: Office Kirkpatrick

(56) References cited:
- US-A- 6 075 253
- US-A1- 2008 153 267
- US-A1- 2009 108 384

## Description

### Field of the disclosure

This disclosure relates to methods for the integration of high-performance waveguide-integrated photodetectors, e.g. Ge waveguide-integrated photodetectors, along with other photonic devices on a silicon photonics platform, e.g. a SOI based photonics platform.

### Background of the disclosure

The realization of a complete silicon based photonics platform requires the co-integration of: advanced passive photonic devices, e.g. using poly-on-SOI, such as for example high-efficiency raised grating couplers, filters, polarization rotators and/or waveguides; advanced electro-optic modulators and switches, such as for example SOSCAP (semiconductor-oxide-semiconductor) modulators e.g. employing the gate-oxide capacitance between poly and SOI, and/or p-n diodes for carrier depletion and injection; hybrid III-V/Si lasers and amplifiers using bonding technology; and Ge-on Si waveguide photodetectors. See US 2009/0108384.

In hybrid III-V/silicon lasers and amplifiers, optical gain is achieved in a low-defect III-V layer that is first grown epitaxially on a separate substrate and then bonded to e.g. a SOI substrate. In order to allow efficient evanescent coupling between the silicon layer and the III-V layer, both layers are in close proximity, preferably at a distance lower than 100 nm. Bonding of the III-V layer with thin interfacial layers requires a flat surface with a low topography.

The co-integrated Ge-on-Si waveguide photodetectors preferably have a good perfomance, such as: a low dark current, requiring a low defect density of threading dislocations (less than 10⁷ per cm²); a high responsivity in the order of 1 A/W, requiring efficient optical coupling between silicon and germanium, low parasitic absorption at the metal contacts and efficient carrier collection; and a high speed, e.g. in the range between 10 GHz and 40 GHz, requiring thin layers and a small footprint.

Ge waveguide photodetectors can for example be integrated with a silicon photonics platform by transferring and wafer bonding a cystalline germanium film onto a silicon based (e,g, SOI) wafer, and then fabricating the photodetector in the transferred film. Using a wafer bonding approach is relatively expensive and makes co-integration with other opto-electronic components difficult, in particular the co-integration with hybrid III-V/silicon lasers, requiring bonding of III-V layers in close proximity to a silicon waveguide.

Ge waveguide photodetectors can also be integrated with a silicon photonics platform by (e.g. epitaxially) growing a Ge layer on top of a silicon waveguide and then fabricating a Ge photodetector. In order to enable co-integration with other opto-electronic components and e.g. hybrid lasers, a planar topology is needed, requiring for example a thin germanium film for the photodetectors (preferably thinner than 300 nm). However, metal contacts on top of such a thin film are known to cause excessive optical absorption which doesn't contribute to the photocurrent, and as such negatively affects the photodetector responsivity. In addition, the negative effect on the photodetector responsivity of defects in a thin Ge layer epitaxially grown on top of silicon is much more pronounced than for a thicker Ge layer.

### Summary of the disclosure

It is an object of embodiments of the present disclosure to provide a method for the co-integration of photonic active and passive devices, high-performance Ge waveguide-integrated photodetectors and hybrid III-V/Si lasers on a silicon based photonics platform.

The above objective is accomplished by a method and device according to the present disclosure.

The present disclosure provides a method for the co-integration of advanced active and passive photonic devices, hybrid III-V/silicon lasers and Ge-on-Si waveguide detectors on a planarized silicon based photonics substrate comprising silicon devices including patterned silicon structures, e.g. waveguide structures, the method comprising: depositing a dielectric layer, e.g. a SiO₂ layer, on top of the planarized silicon based photonics substrate; etching trenches into the dielectric layer with an appropriate etch depth, thereby exposing a patterned silicon waveguide structure of the photonics substrate; selective etching of the exposed waveguide structure, thereby creating a template for Ge growth and leaving a thin silicon layer as a seed layer for Ge growth; selectively growing Ge from the seed layer, with a deliberate Ge overgrowth, such as e.g. about 1 micrometer Ge overgrowth; optionally but advantageously a post-growth annealing to reduce the defect density in the Ge layer; and planarizing the Ge layer, for instance by CMP (Chemical Mechanical Polishing), thereby leaving a Ge layer with a thickness for example in the order of 100 to 500 nm, or for example in the order of 250 nm to 300 nm. The method of the present disclosure further comprises processing of the Ge photodetector, for instance comprising creating doped regions in the Ge layer, e.g. by implantation, and silicidation of both Ge and Si regions. Furthermore, III-V layers can be bonded to the substrate for the integration of hybrid III-V silicon lasers. After laser processing a common BEOL (Back-End Of Line) process can be performed to contact the lasers, Ge photodetectors and silicon devices.

The silicon based photonics substrate or silicon based photonics platform comprises photonic structures and photonic devices, such as for example waveguide structures, grating couplers, filters and/or modulators, wherein a silicon / dielectric material system is used for realising the optical functionalities. It can for example be a Si / SiO₂ material system, e.g. based on an SOI (Silicon On Insulator) wafer. This silicion based photonics substrate is preferably planarized, i.e. it has preferably a substantially planar surface.

In embodiments of the present disclosure the template for Ge growth is selected such that it allows fabricating thin Ge photodetectors with a good performance, i.e. with a high responsivity, a low dark current, and a high speed. In a first aspect the template for Ge growth is selected such that an 'inverted rib' (T-shaped) Ge layer is obtained, for instance comprising a 100 nm to 500 nm, preferably 250 nm to 300 nm, thick optically active region with thinner (e.g. 50 nm thin) laterally overhanging parts on which metal contacts are provided. In operation, light is confined in the optically active region and is kept away from the metal contacts, thus substantially limiting absorption losses at the metal contacts. In a second aspect the template for Ge growth is selected such that a 'laterally overgrown' (L-shaped) Ge layer is obtained, wherein the optically active region (having e.g. a thickness in the order of 100nm to 500 nm, preferably 250 nm to 300 nm) in the Ge is formed by lateral overgrowth over a silicon waveguide, with a thin dielectric layer in between the silicon waveguide and the optically active region of the Ge photodetector. The optically active region of the Ge is laterally disposed, e.g. at a lateral distance (of for example 300 nm to 1000 nm) from the seed layer, and thus at a lateral distance from defects near the seed layer, e.g. resulting in a low dark current, such that the dark current is for instance below a predetermined threshold. The metal contacts to the Ge photodetector are preferably provided at a distance (of for example 50 nm or more) from the optically active region such that absorption losses at the contacts can be limited, for instance limited below a predetermined threshold.

In a method of the present disclosure, after processing the Ge photodetectors, a planar topology is obtained. The method may further comprise bonding of III-V layers to the substrate for the integration of hybrid III-V silicon lasers. A thin dielectric layer having a thickness less than 100 nm, preferably less than 50 nm, e.g. a 30 nm thin oxide layer can be provided on this planar surface, after which for instance bonding of these III-V layers can be done, e.g. for fabricating III-V/Si hybrid lasers with good coupling to the underlying silicon structures. According to preferred embodiments of the present invention, the III-V layers are provided at a vertical distance from a silicon waveguide structure of the photonics substrate which is smaller than 100nm, or smaller than 50 nm or smaller than 30 nm.

According to preferred embodiments, the method further comprises performing a single, common BEOL (Back-End Of Line) process to contact the III-V/silicon hybrid lasers, Ge photodetectors and silicon devices.

According to preferred embodiments, providing the planarized silicon based photonics substrate comprises providing silicon based dummy structures on the silicon based photonics substrate and planarizing the silicon based photonics substrate by CMP. In such preferred embodiments at least a substantial amount of silicon based dummy structures can be used as a seed layer for Ge growth, thereby creating Ge based dummy structures (or Ge dummies) levelling out the density of Ge over the substrate, thus allowing good planarization of the Ge layer by means of CMP. It is an advantage that the silicon based dummy structures can be reused for creating Ge based dummy structures.

It is an advantage of a method of the present disclosure that it fits within an existing framework, that it is CMOS compatible, and that it allows obtaining good high-performance Ge photodetectors combined with the integration of III-V/Si lasers. It is an advantage that after the integration of the Ge waveguide-integrated photodetector a planar topology is obtained, with only a thin dielectric layer (thickness less than 100 nm, preferably less than 50 nm) on top of the silicon waveguides. This allows subsequent integration of hybrid III-V/Si lasers, which rely on a thin interfacial dielectric layer between the silicon and the III-V layers to obtain optimum lasing performance.

It is an advantage that the process of the present disclosure fits within an existing platform or framework for silicon based photonics processing, and that sharing of the contact module between all devices (lasers, Ge photodetectors, silicon devices) is enabled, potentially leading to a cost reduction.

For purposes of summarizing the disclosure and the advantages achieved over the prior art, certain objects and advantages of the disclosure have been described herein above. Of course, it is to be understood that not necessarily all such objects or advantages may be achieved in accordance with any particular embodiment of the disclosure. Thus, for example those skilled in the art will recognize that the disclosure may be embodied or carried out in a manner that achieves or optimizes one advantage or group of advantages as taught herein without necessarily achieving other objects or advantages as may be taught or suggested herein. Further, it is understood that this summary is merely an example and is not intended to limit the scope of the disclosure as claimed. The disclosure, both as to organization and method of operation, together with features and advantages thereof, may best be understood by reference to the following detailed description when read in conjunction with the accompanying drawings.

### Brief description of the drawings

FIG. 1 to FIG. 8 schematically illustrate process steps of an example method according to the present disclosure.
FIG. 9 illustrates the integration of a hybrid III-V/silicon laser according to the present disclosure.
FIG. 10 shows a TEM cross section of an 'inverted rib' Ge structure.
FIG. 11 illustrates different device configurations for an 'inverted rib' Ge waveguide-integrated photodetector that can be used in embodiments of the present disclosure.
FIG. 12 shows simulation results for a prior art Ge waveguide-integrated photodetector (FIG. 12(b)) and for an 'inverted rib' Ge waveguide-integrated photodetector according to an embodiment of the present disclosure (FIG. 12(a)).
FIG. 13 schematically illustrates process steps of an exemplary method according to the present disclosure.
FIG. 14 illustrates different device configurations for a 'laterally overgrown' Ge waveguide-integrated photodetector that can be used in embodiments of the present disclosure.
Fig. 15 and Fig. 16 illustrate experimental results comparing a state of the art Ge photodetector with a Ge photodetector according to embodiments of the present invention.

Any reference signs in the claims shall not be construed as limiting the scope of the present disclosure.

In the different drawings, the same reference signs refer to the same or analogous elements.

### Detailed description of the disclosure

In the following detailed description, numerous specific details are set forth in order to provide a thorough understanding of the disclosure and how it may be practiced in particular embodiments. However, it will be understood that the present disclosure may be practiced without these specific details. In other instances, well-known methods, procedures and techniques have not been described in detail, so as not to obscure the present disclosure. While the present disclosure will be described with respect to particular embodiments and with reference to certain drawings, the disclosure is not limited hereto. The drawings included and described herein are schematic and are not limiting the scope of the disclosure. It is also noted that in the drawings, the size of some elements may be exaggerated and, therefore, not drawn to scale for illustrative purposes.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the disclosure described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the disclosure described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B.

The present disclosure provides an integration process, allowing the co-integration of photonic active and passive devices and high-performance waveguide-integrated photodetectors, e.g. high-performance Ge waveguide-integrated photodetectors and the hybrid integration of light sources, e.g. hybrid III-V/Si lasers on a single silicon based photonics platform.

Such co-integration requires a planar technology, wherein the thickness of the Ge layers used for forming Ge photodetectors is preferably less than 300 nm.

The method of the present disclosure comprises: depositing a dielectric layer on top of a planarized silicon based photonics substrate comprising patterned silicon structures; etching a trench into the dielectric layer with an appropriate etch depth, thereby exposing a patterned silicon waveguide structure of the photonics substrate; selectively etching the exposed waveguide structure, thereby creating a template for Ge growth and leaving a thin silicon layer as a seed layer for Ge growth; selectively growing a Ge layer using the exposed silicon of the etched waveguide as a seed layer, with a deliberate Ge overgrowth; post-growth annealing to reduce the defect density in the Ge layer; and CMP (Chemical Mechanical Polishing) of Ge to planarize the surface such that a planar structure is obtained and leaving a Ge layer with a thickness for example in the order of 250 nm to 300 nm. The method of the present disclosure further comprises processing of the Ge photodetector, comprising creating doped regions in the Ge layer, e.g. by implantation.

In embodiments of the present disclosure the template for Ge growth is selected such that it allows fabricating thin Ge photodetectors with a good performance, i.e. with a high responsivity, a low dark current, and a high speed. In a first aspect, in order to avoid that metal contacts on such a thin Ge film cause excessive optical absorption losses, leading to a low performance of the Ge photodetectors, a design is proposed wherein the metal contacts are provided at a distance from the optically active region. This is obtained by providing an 'inverted rib' Ge photodetector, wherein the Ge is patterned such that it comprises an optically active region (e.g. 100 nm to 500 nm, preferably 250 nm to 300 nm thick) and laterally overhanging elements or parts (e.g. about 50 nm thick), resulting in a T-shape, and wherein metal contacts are provided on these overhanging elements. The laterally overhanging parts are thin, e.g. in the order of 50 nm, to confine the optical mode to the thicker, e.g. 250 nm to 300 nm thick, optically active region. The metal contacts are provided on these thin Ge layers that are laterally connected to the Ge optically active region. The light is mainly confined to the thicker Ge region and is thus kept away from the metal contacts, thereby strongly limiting absorption losses at the contacts. In a second aspect, in order to additionally minimize the influence of defects in the thin Ge layer grown on top of the silicon seed layer, a 'laterally overgrown' Ge waveguide-integrated photodetector on top of a silicon waveguide is provided. In this aspect, the optically active Ge region is formed by lateral overgrowth over a silicon waveguide, with a thin (less than 100 nm) dielectric layer in between the laterally overgrown Ge layer and the silicon waveguide layer. The optically active region of the Ge layer is at a predetermined lateral distance from the seed layer, and thus the optically active region is at a lateral distance from the defects near the seed layer. In addition, the metal contacts are preferably provided at a distance from the optically active region to minimize absorption losses at the metal contacts.

According to the present disclosure, the 'inverted rib' Ge structure and the 'laterally overgrown' Ge structure are formed by selective Ge growth seeded from a silicon layer at the bottom of an oxide trench with an appropriate etch depth and profile. As described above, the oxide trench thereby forms a template for the Ge growth and an etched silicon waveguide is used as a seed layer.

After integration of the Ge photodetectors, a planar structure is obtained. In a later phase of the process, III-V layers can be bonded to this planar structure, e.g. for fabricating integrated III-V/silicon hybrid lasers. After laser processing a common BEOL (Back-End Of Line) approach can be used to contact the lasers, Ge photodetectors and silicon devices.

A process of the present disclosure fits within an existing framework or platform for silicon photonics processing. It is CMOS compatible, and it allows obtaining good Ge photodetectors combined with the integration of III-V/Si lasers. After the integration of the Ge waveguide-integrated photodetectors a planar topology is obtained, with only a thin dielectric layer (thickness less than 100 nm, preferably less than 50 nm) on top of the silicon waveguides. This allows subsequent integration of hybrid III-V/Si lasers, which rely on a thin interfacial dielectric layer between the silicon and the III-V layers to obtain optimum lasing performance. In a process of the present disclosure sharing of the contact module between all devices (lasers, Ge photodetectors, silicon devices) is enabled, potentially leading to a low cost process.

The method of the present disclosure is further described for an exemplary process flow, with a focus on the process steps for forming the Ge photodetectors. However, the present disclosure is not limited thereto. For example, in the different process steps other suitable materials, other suitable process parameters (such as temperatures, process times, ...) and other suitable dimensions can be used. Other devices than the ones illustrated can be integrated.

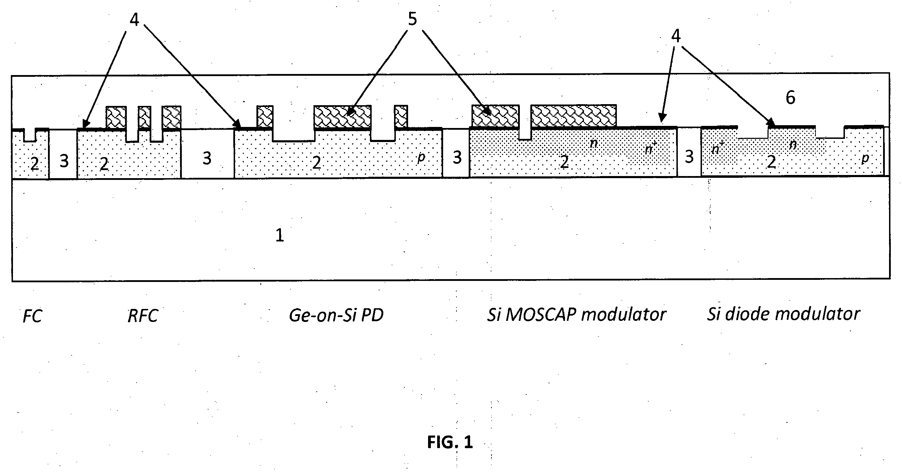

Process steps of an exemplary process flow according to an embodiment of the present disclosure are schematically illustrated in FIG. 1 to FIG. 8. In these drawings, the process of the present disclosure is illustrated for an example wherein a waveguide/grating coupler (FC), a raised grating coupler (RFC), a Ge-on-Si photodetector (PD), a Si MOSCAP modulator and a Si diode modulator are integrated on a silicon-based photonics platform.

In the example shown, a photonics SOI wafer is used, the SOI wafer comprising a 2000 nm thick BOX (Buried Oxide) layer with a lightly p-doped, 220 nm thick silicon layer on top. FIG. 1 shows a cross section of a planarized silicon based photonics substrate that has been processed in accordance with an existing silicon photonics platform, e.g. as reported by D. Vermeulen et al in "High-efficiency fiber-to-chip grating couplers realized using an advanced CMOS-compatible Silicon-On-Insulator platform", Optics Express, Vol. 18 No. 17, 16 August 2010, pp 18278-18283. FIG. 1 shows the 2000 nm BOX layer 1, a patterned (220 nm thick) silicon layer 2 that is doped where needed for realizing the photonics devices to be formed, with oxide regions 3 in between the silicon structures 2, a gate oxide layer 4, poly structures 5, and an oxide layer 6 having a planar surface.

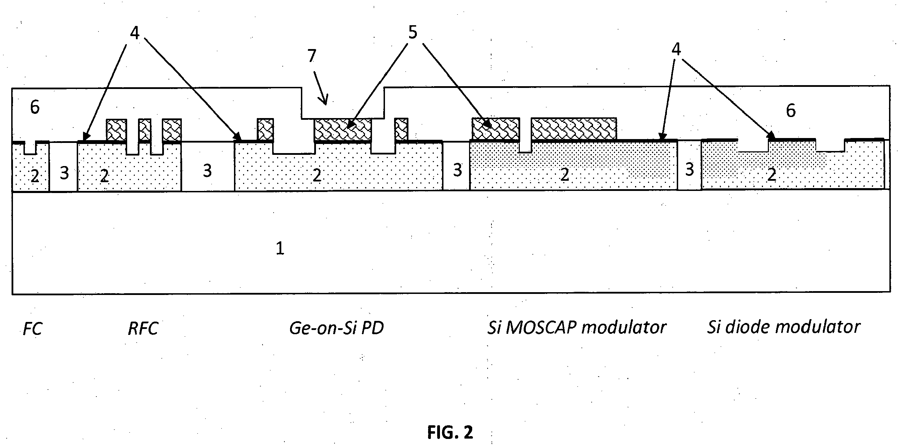

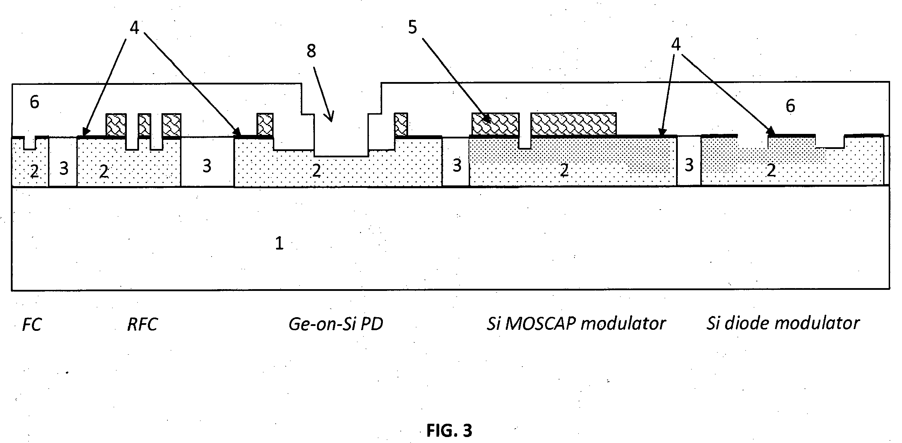

In the following steps, a template for Ge growth is formed. FIG. 2 illustrates etching of a trench 7 through the oxide layer 6 such that an underlying poly layer 5 is exposed, at the location where Ge growth for forming a Ge photodetector is to be initiated. FIG. 3 illustrates the resulting structure after etching through the poly layer 5 (stopping on the gate oxide layer 4), etching the gate oxide layer 4, and etching into the underlying crystalline silicon structure 2 to a depth e.g. in the range between 70 nm and 150 nm. In this way a template 8 for Ge growth is formed. Next a cleaning step is performed, followed by an HF dip and an in-situ H2 bake at 850ºC. Then in-situ HCl vapor etching of about 50 nm of silicon is performed in order to have a good seed layer surface. In this process, the photoresist (used for the patterning steps) is preferably removed after poly etching and before gate oxide etching, without exposing the silicon layer. This is advantageous for the cleanliness of the silicon seed layer surface.

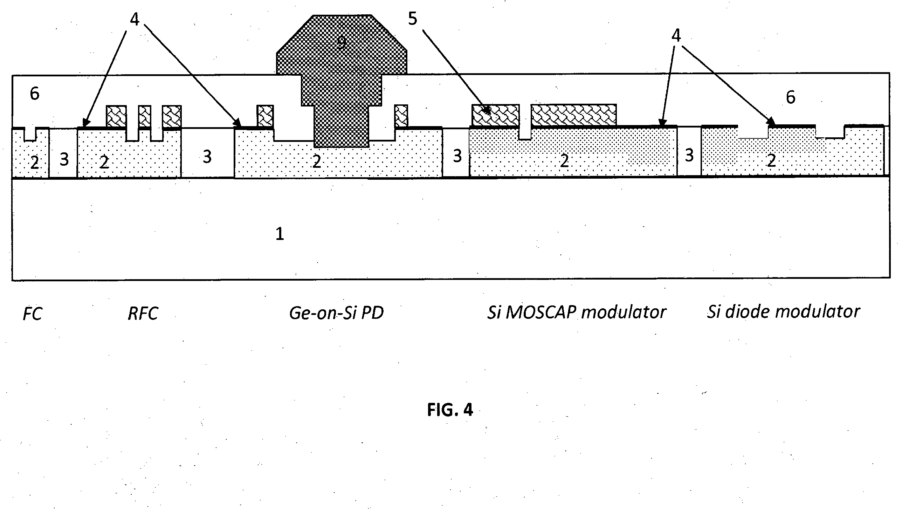

The next step in the process is the selective growth of a Ge layer 9, using the exposed silicon as a seed layer (FIG. 4) and using the step-shaped trench 8 (FIG. 3) as a template. The thickness of the Ge layer 9 can for example be in the order of 1 micrometer to 2 micrometer. For more advanced devices there may additionally be a need for silicon epitaxial growth and/or in-situ doping.

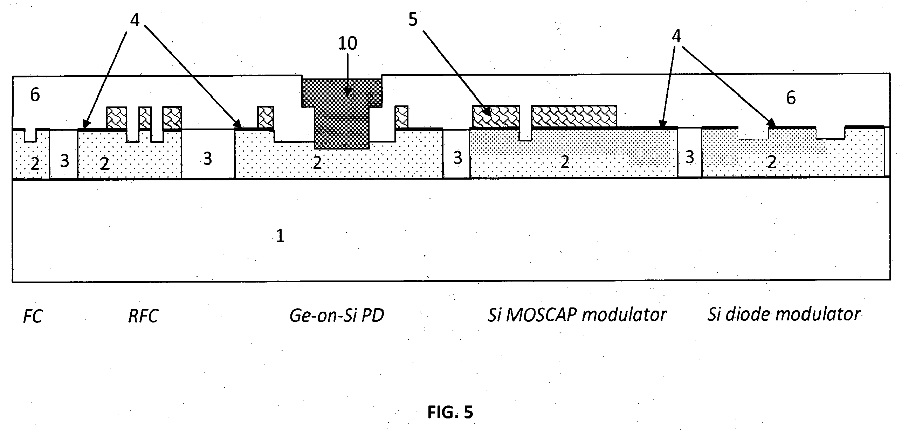

After a Ge post-growth anneal (e.g. 3 minutes at 850ºC in a nitrogen atmosphere) to reduce the number of defects, a Ge CMP step, stopping on the silicon oxide layer 6 is performed (FIG. 5). In order to be able to better control the Ge CMP process, Ge based dummy structures or Ge dummies can be provided that level out the density of Ge over the substrate. These Ge dummies can for example be formed at the location of silicon based dummy structures used in the fabrication process of the planarized silicon based photonics substrate shown in Figure 1. For example, the Ge dummies can be fabricated using the silicon based dummy structures as a seed layer for Ge growth. After Ge CMP, the thickness of the remaining Ge layer 10 is preferably in the order of 100 nm to 500 nm, preferably in the order of 250 nm to 300 nm.

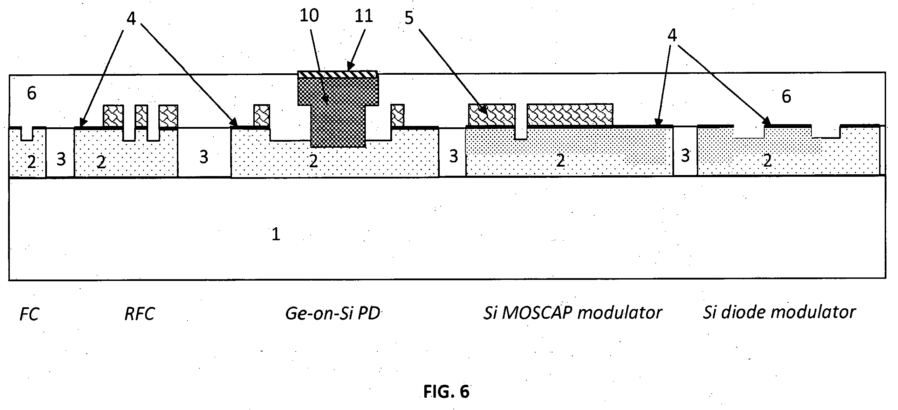

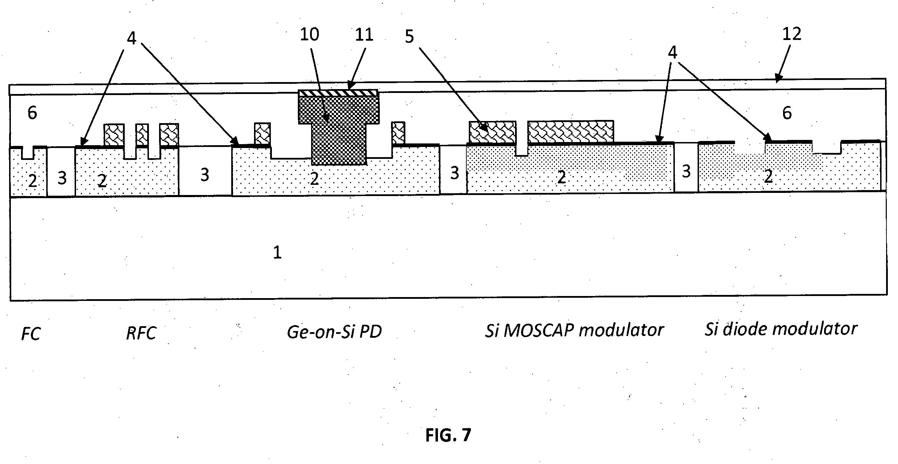

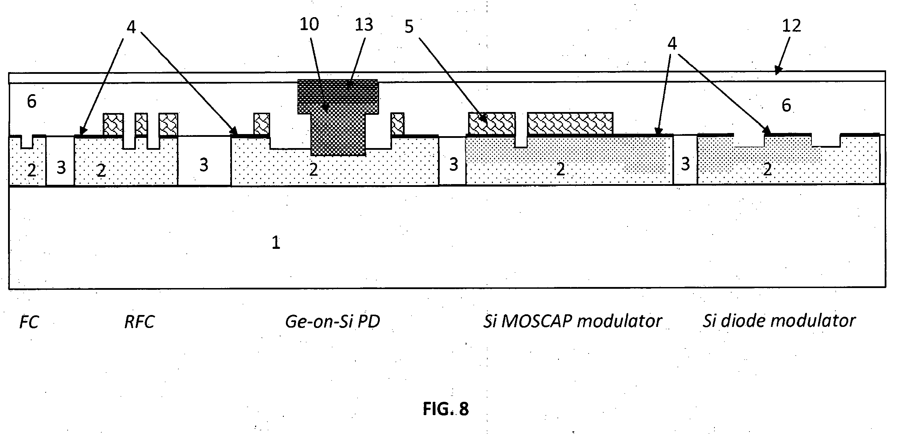

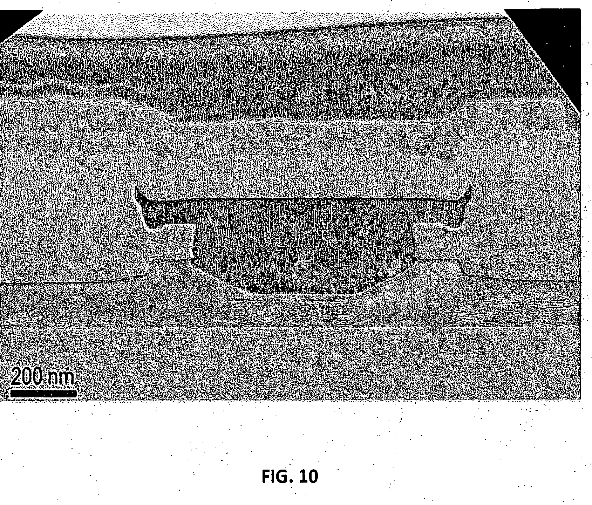

This step is followed by the growth of a 20 nm thick Si_{0.50}Ge_{0.50} cap 11 (selective with respect to the oxide 6) as illustrated in FIG. 6, to enable in a later process step collective silicidation with the silicon devices. This is followed by the growth of a PECVD oxide liner 12 (FIG. 7) having a thickness less than 100 nm, preferably less than 50 nm, e.g. about 30 nm. Next, n+ implants 13 (e.g. phosphorous) and/or p+ implants (e.g. boron) in the Ge layer are performed, followed by an activation anneal, for forming a photodetector structure (vertical p-i-n in the example shown in FIG. 8). In the example shown in FIG. 8, the Ge photodetector has an 'inverted rib' structure. A TEM cross section of such an 'inverted rib' structure is shown in Figure 10.

At this stage of the process, a planar structure comprising photonic devices and an integrated Ge photodetector on a silicon photonics platform is obtained. The top oxide layer 12 is thin, e.g. 30 nm thin, allowing further integration of e.g. III-V/Si hybrid lasers with good coupling to the underlying silicon photonics structures.

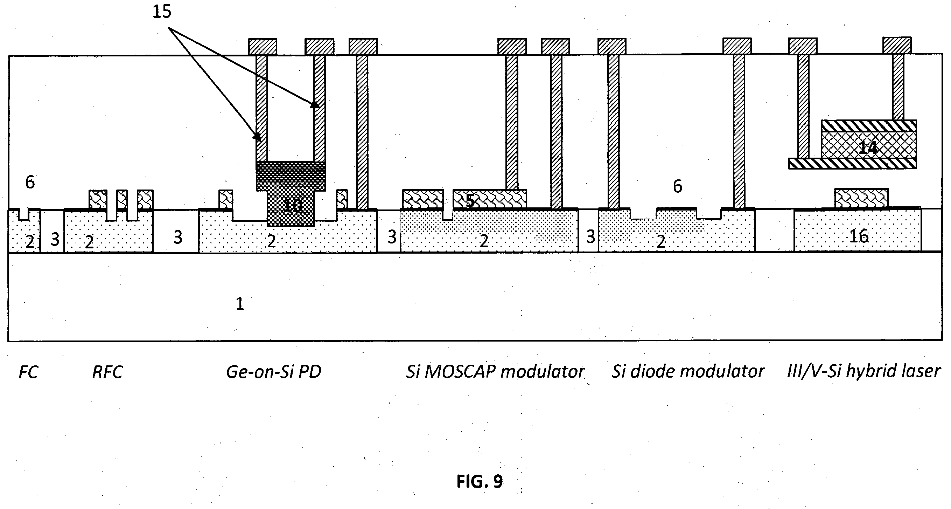

Integration of a III-V device is schematically illustrated in FIG. 9, showing an integrated III-V layer 14 that allows good optical coupling to an underlying silicon waveguide structure 16. Further process steps, after bonding of the III-V layer, are mainly related to laser processing and forming contacts and interconnects. In a process of the present disclosure, a single contact module can be used for forming the contacts to the silicon devices, Ge photodetectors and hybrid lasers (FIG. 9).

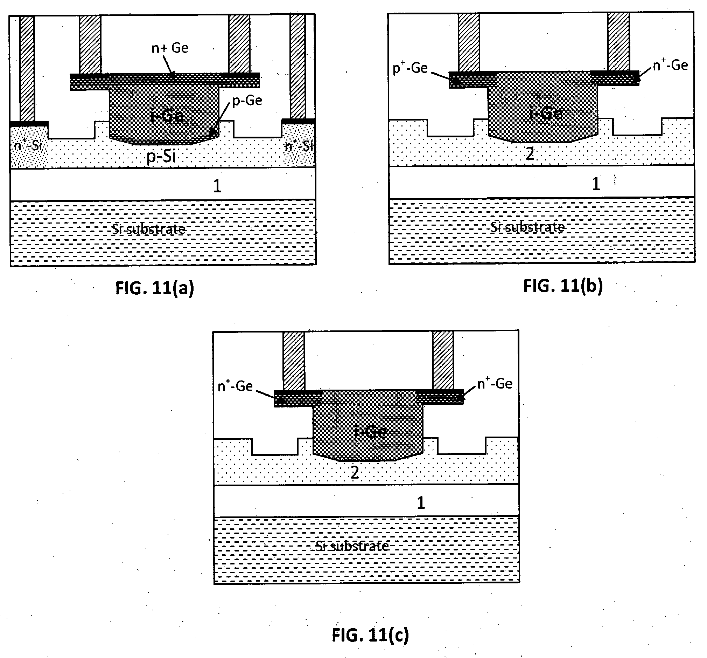

As can be seen in FIG. 9, in the example shown the shape of the Ge layer 10 is an 'inverted rib' Ge structure comprising thin laterally overhanging elements on which metal contacts 15 are provided. This is also illustrated in FIG. 11 for different electrical design variants of the Ge photodetector. FIG. 11 (a) illustrates a vertical p-i-n structure; FIG 11 (b) illustrates a lateral p-i-n structure and FIG. 11 (c) illustrates a lateral Metal-Semiconductor-Metal structure. The metal, contacts are provided on the thin laterally overhanging parts of the Ge structure, away from the optically active region such that optical losses at the metal contacts are strongly reduced, leading to a high responsivity of the Ge photodetector.

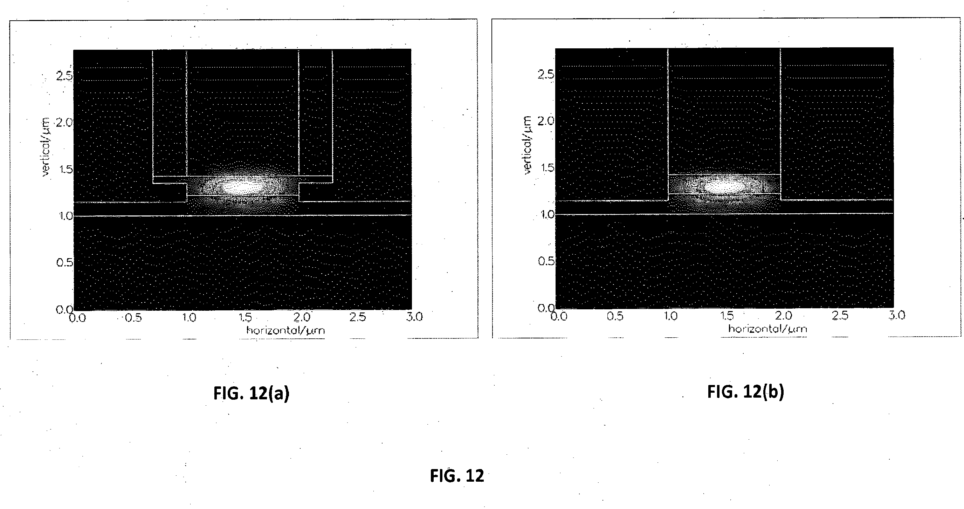

FIG. 12 shows results of simulations performed for an 'inverted rib' Ge photodetector according to the present disclosure as described above (FIG. 12(a)) and for a prior art Ge waveguide-integrated photodetector with a metal contact on top of the optically active region of the Ge photodetector (FIG. 12(b)). Simulations were performed at a wavelength of 1.5 micrometer, assuming a Ge waveguide that is 1 micrometer wide and 0.21 micrometer thick. The simulations revealed that in the case of an 'inverted rib' Ge photodetector the absorption coefficient of the optical mode is about 4400/cm and that absorption mainly occurs in the germanium, leading to a maximum quantum efficiency approaching 100%. In case of a prior art Ge photodetector, the simulation shows that the absorption coefficient of the optical mode is about 7400/cm, of which about 3000/cm is related to absorption in the metal, resulting in a maximum quantum efficiency of less than 60%.

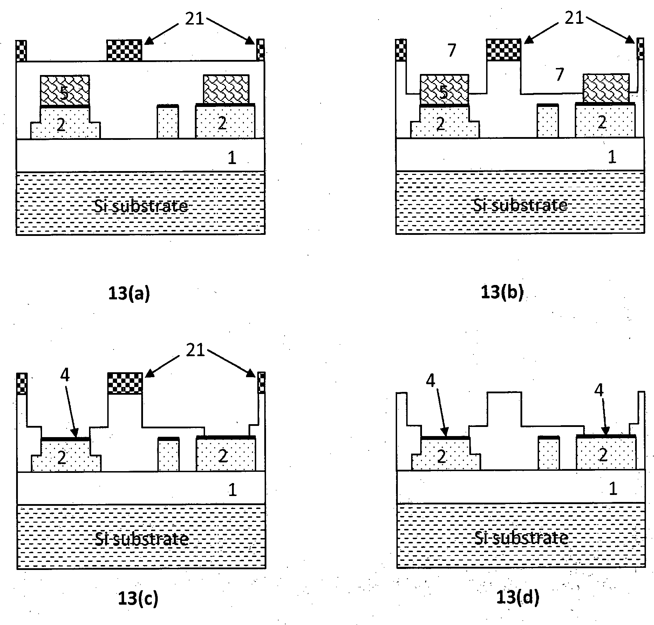

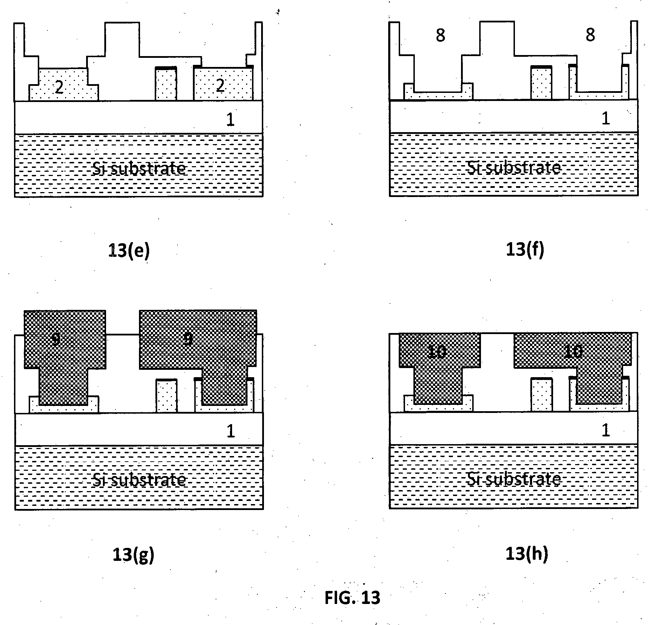

FIG. 13 schematically illustrates a fabrication process of the present disclosure, illustrating fabrication of an 'inverted rib' Ge waveguide-integrated photodetector according to the first aspect and fabrication of a 'laterally overgrown' Ge waveguide-integrated photodetector according to the second aspect.

The basis of Fig. 13(a) is a planarized silicon based photonics platform. The platform comprises a stack of gate oxide 4 / polycrystalline silicon 5 on a Silicon on Insulator (SOI) substrate (typical thicknesses: 160nm polycrystalline silicon 5 / 5nm gate oxide 4, on top of the SOI substrate with for instance 220 nm thick silicon 2 and 2 micron thick Buried oxide (Box) 1). Four or five levels of patterning have typically been performed, comprising for instance lithography and/or etching of polycrystalline silicon / silicon etching, to define advanced optical features or structures in the silicon. After the silicon patterning steps, the process of fabricating the silicon based photonics platform further comprises a step of depositing an oxide and planarization of the deposited oxide, for instance by Chemical Mechanical Polishing (CMP). This CMP step can be stopped at a SiN layer on top of the patterned polycrystalline silicon. Preferably dummy polycrystalline silicon structures covered with SiN are provided across the substrate to level out the density of polycrystalline silicon structures accross the wafer, thus allowing good CMP process control. After CMP the SiN layer is removed and the oxide in between is etched back such that a planar surface if obtained. Next an oxide layer, e.g. a 150 nm thick oxide layer is deposited on the entire surface. The resulting silicon based photonics platform is also illustrated in FIG. 1.

FIG. 13(a) shows a stage of the process just before the step of forming a template for Ge growth in the oxide layer. FIG. 13(a) illustrates providing a patterned resist layer 21 for defining the oxide template by means of for instance lithography techniques. FIG. 13(b) illustrates etching of trenches through the oxide layer 6 such that the underlying polycrystalline silicon layer 5 is exposed, at the location where Ge growth for forming a Ge photodetector is to be initiated. Preferably, this is a timed oxide etch, exposing poly-silicon structures 5, wherein the etch time determines remaining oxide thickness on top of the silicon waveguide structures 2. In the example shown, the trench at the left is shaped to realize an 'inverted rib' Ge structure; the trench at the right is shaped such that it overlies a silicon waveguide, intended for realizing a 'laterally overgrown' Ge structure. FIG. 13(c) illustrates the step of etching through the polycrystalline silicon layer 5 (for instance stopping on the gate oxide 4). A step-like template in the oxide is thereby created, possibly running over underlying Si waveguide structures. After stripping the resist layer (FIG. 13(d)) the gate oxide layer is selectively etched (FIG. 13(e)), followed by in-situ cleaning and etching into the crystalline silicon layer to a depth e.g. in the range between 70 nm and 150 nm (FIG. 13(f)). The next step in the process is the selective Ge growth, for instance to a thickness of 0.5 to 5 micron, using the exposed silicon as a seed layer (FIG. 13(g)) and using the step-shaped oxide trenches as a template. Advantageously, a post growth anneal to remove dislocation defects is performed. The removal of defects is thereby typically better for thicker layers than for thinner layers. Afterwards,Ge CMP is performed (FIG. 13(h)). The final thickness of the Ge layer is estimated to be within the range of 100 nm to 500 nm, typically about 300 nm. In the example illustrated, both an 'inverted rib' structure (left) and a 'laterally overgrown' structure (right) are obtained. The Ge CMP process control requires equal density of Ge islands across the wafer/design, which can be provided by providing Ge dummy structures across the wafer. A single, common back-end-of-line (BEOL) contacting process or strategy can be performed for Ge devices and other active Si optical devices on the same substrate.

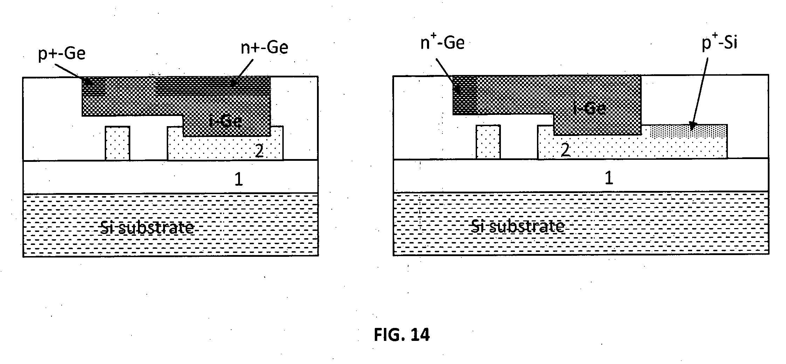

As an example, FIG. 14 illustrates two different device configurations that may be used for the 'laterally overgrown' Ge waveguide-integrated photodetector in embodiments of the present disclosure. Note that in between (in vertical direction) the Ge active region (laterally overgrown part) and the silicon waveguide structure (underneath the Ge active region) there is a thin oxide layer. The left drawing shows a lateral p-i-n structure with both contacts to the Ge, while the right drawing shows a lateral p-i-n structure with one of the contacts (in the example shown the p+ contact) made to the silicon layer.

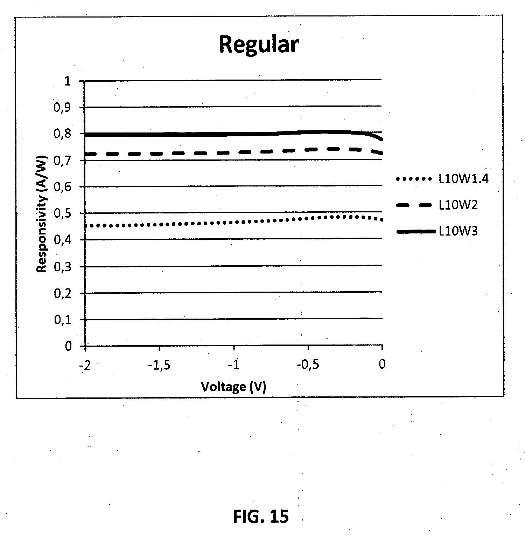

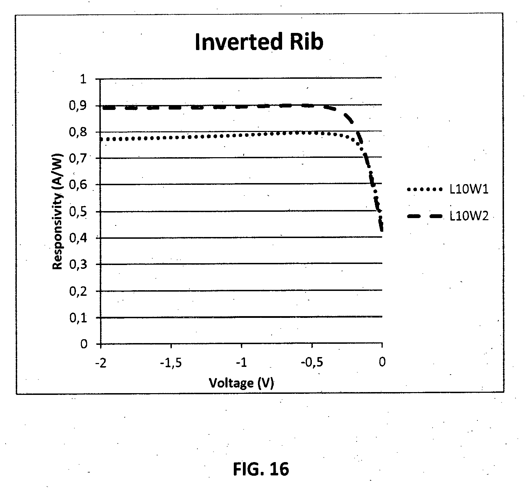

Experimental results with respect to the measured responsivity as a function of device width, both for 'regular' (Fig. 15) and 'inverted rib' (Fig. 16) Ge photodetector structures, for a wavelength of 1.5 micrometer, are provided. The final thickness of the Ge layer was about 200 nm. Results are shown for devices with 10 micrometer length (L10) and for different widths (W=1.4 micron, 2 micron, 3 micron and 1 micron, 2 micron respectively). It can be concluded that for the same device size, a clearly better responsivity is obtained for the inverted rib structure according to aspects of the present invention as compared to a "regular" Ge photodetector. It can also be concluded that the responsivity is much less influenced by device width in the case of an inverted rib structure as compared to a regular structure.

Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details certain embodiments of the invention. It will be appreciated, however, that no matter how detailed the foregoing appears in text, the invention may be practiced in many ways within the scope of the claims. It should be noted that the use of particular terminology when describing certain features or aspects of the invention should not be taken to imply that the terminology is being re-defined herein to be restricted to include any specific characteristics of the features or aspects of the invention with which that terminology is associated.

## Claims

1. A method for the co-integration of photonic devices, Ge waveguide-integrated photodetectors and hybrid III-V/Si lasers on a silicon based photonics platform, the method comprising:
- providing a planarized silicon based photonics substrate comprising silicon devices including patterned silicon waveguide structures (2);
- depositing a dielectric layer (6) on top of the planarized silicon based photonics substrate;
- etching trenches (7) into said dielectric layer (6) with an appropriate etch depth, thereby exposing a patterned silicon waveguide structure (2) of said photonics substrate at a location where Ge growth for forming a Ge photodetector is to be initiated;
- the step of etching trenches followed by a step of
selective etching of the exposed waveguide structure (2), thereby creating a template for Ge growth and leaving a silicon seed layer for Ge growth;
- selectively growing Ge from said seed layer, with a deliberate Ge overgrowth;
- planarizing the Ge surface, leaving a Ge layer with a reduced thickness.

2. Method according to claim 1, wherein selective etching of the exposed waveguide structure comprises etching to a depth in the range between 70 nm and 150 nm.

3. Method according to claim 1 or 2, further comprising a post-growth annealing to reduce the defect density in the Ge layer, before planarizing said Ge surface.

4. Method according to claim 1 to 3, wherein said Ge layer with a reduced thickness has a thickness between 100 and 500 nm.

5. Method according to claim 1 to 4, wherein planarizing said Ge surface comprises a CMP process.

6. Method according to any of the previous claims, further comprises processing of a Ge photodetector.

7. Method according to any of the previous claims, further comprising providing metal contacts to the Ge photodetector at a distance from the optically active region such that absorption losses at the contacts are limited below a predetermined threshold.

8. Method according to any of the previous claims, further comprising selecting the template for Ge growth such that an inverted rib, for instance T-shaped, Ge layer is obtained.

9. A method according to claim 8, wherein said inverted rib comprises a 250 nm to 300 rim thick optically active region with thinner laterally overhanging parts on which metal contacts can be provided.

10. A method according to any of the previous claims, wherein the template for Ge growth is selected such that a laterally overgrown, for instance L-shaped Ge layer is obtained, wherein the optically active region in the Ge is formed by lateral overgrowth over a silicon waveguide.

11. Method according to claim 10, wherein the template for Ge growth is selected such that the optically active region of the Ge is laterally disposed from, e.g. is at a lateral distance of, the seed layer, and thus at a sufficiently large lateral distance from defects near the seed layer, in order to reduce a dark current below a predetermined threshold.

12. Method according to any of the previous claims, further comprising bonding III-V layers to the substrate for the integration of hybrid III-V silicon lasers.

13. Method according to claim 12, wherein said III-V layers are provided at a vertical distance from a silicon waveguide structure of said photonics substrate which is smaller than 100 nm.

14. Method according to any of claims 12 or 13, further comprising performing a single, common Back-End-Of-Line process to contact the hybrid III-V silicon lasers, Ge photodetectors and silicon devices.

15. Method according to any of the previous claims, wherein providing said planarized silicon based photonics substrate comprises providing dummy structures on said silicon based photonics substrate and planarizing said silicon based photonics substrate by CMP, and wherein said dummy structures are used as a seed layer for Ge growth, thereby creating Ge based dummy structures allowing good planarization of the Ge layer by means of CMP.

## Patentansprüche

1. Verfahren für die Ko-Integration von Photonenvorrichtungen, Ge-Wellenleiterintegrierten Photodetektoren und Hybrid III-V/Si Laser auf einer auf Silizium basierten Photonik-Plattform, wobei das Verfahren umfasst:
- Bereitstellen eines plangemachten Photonik-Substrats auf Silizium-Basis, welches Silizium-Vorrichtungen, darunter strukturierte Siliziumwellenleiterstrukturen (2), umfasst;
- Ablagern einer dielektrischen Schicht (6) auf dem plangemachten Photonik-Substrat auf Silizium-Basis;
- Ätzen von Gräben (7) in die dielektrische Schicht (6) mit einer richtigen Ätztiefe, wodurch eine strukturierte Siliziumwellenleiterstruktur (2) des Photonik-Substrats an einer Stelle, wo Ge-Wachstum zum Ausbilden eines Ge-Photodetektors eingeleitet werden soll, freigelegt wird;
- den Schritt des Ätzens von Gräben, gefolgt von
ausgewähltem Ätzen der freigelegten Wellenleiterstruktur (2), wodurch eine Vorlage für Ge-Wachstum erzeugt wird und eine Siliziumsaatschicht zurückgelassen wird;
- ausgewähltes Wachsen von Ge auf der Saatschicht mit einer absichtlichen Ge-Überwucherung;
- Planmachen der Ge-Oberfläche unter Zurücklassen einer Ge-Schicht mit einer verringerten Dicke.

2. Verfahren nach Anspruch 1, wobei das ausgewählte Ätzen der freigelegten Wellenleiterstruktur das Ätzen bis auf eine Tiefe im Bereich zwischen 70 nm und 150 nm umfasst.

3. Verfahren nach Anspruch 1 oder 2, des Weiteren umfassend ein Tempern nach dem Wachstum, um die Defektdichte in der Ge-Schicht zu verringern, bevor die Ge-Oberfläche plangemacht wird.

4. Verfahren nach Anspruch 1 bis 3, wobei die Ge-Schicht mit einer verringerten Dicke eine Dicke zwischen 100 und 150 nm aufweist.

5. Verfahren nach Anspruch 1 bis 4, wobei Planmachen der Ge-Oberfläche einen CPM-Prozess umfasst.

6. Verfahren nach einem beliebigen der vorangehenden Ansprüche, des Weiteren umfassend das Verarbeiten eines Ge-Photodetektors.

7. Verfahren nach einem beliebigen der vorangehenden Ansprüche, des Weiteren umfassend das Vorsehen von Metallkontakten am Ge-Photodetektor in einem Abstand vom optisch aktiven Bereich, so dass die Absorptionsverluste an den Kontakten unter einem vorbestimmten Schwellenwert beschränkt sind.

8. Verfahren nach einem beliebigen der vorangehenden Ansprüche, des Weiteren umfassend das Auswählen der Vorlage für das Ge-Wachstum, so dass eine invertierte Rippen-, zum Beispiel T-förmige, Ge-Schicht erzielt wird.

9. Verfahren nach Anspruch 8, wobei die invertierte Rippe einen 250 nm bis 300 nm dicken, optisch aktiven Bereich mit dünneren, seitlich überhängenden Teilen umfasst, auf welchen Metallkontakte vorgesehen werden können.

10. Verfahren nach einem beliebigen der vorangehenden Ansprüche, wobei die Vorlage für das Ge-Wachstum so ausgewählt ist, dass eine seitlich überwucherte, zum Beispiel L-förmige, Ge-Schicht erzielt wird, wobei der optische aktive Bereich in der Ge-Schicht durch seitliches Überwuchern über einen Siliziumwellenleiter ausgebildet wird.

11. Verfahren nach Anspruch 10, wobei die Vorlage für Ge-Wachstum so ausgewählt ist, dass der optische aktive Bereich der Ge-Schicht seitlich angeordnet von, z.B. sich in einem seitlichen Abstand befindet zur, Saatschicht und sich folglich in einem ausreichend großen seitlichen Abstand von Defekten nahe der Saatschicht befindet, um einen Dunkelstrom unter einen vorbestimmten Schwellenwert zu verringern.

12. Verfahren nach einem beliebigen der vorangehenden Ansprüche, des Weiteren umfassend das Verbinden von III-V-Schichten mit dem Substrat für die Integration von Hybrid III-V Silizium-Lasern.

13. Verfahren nach Anspruch 12, wobei die III-V Schichten in einem vertikalen Abstand von einer Siliziumwellenleiterstruktur des Photonik-Substrats bereitgestellt werden, welcher kleiner ist als 100 nm.

14. Verfahren nach einem beliebigen der Ansprüche 12 oder 13, des Weiteren umfassend das Ausführen eines einzigen gemeinsamen Back-End-Of-Line Prozesses, um die Hybrid III-V Silizium-Laser, Ge-Photodetektoren und Siliziumvorrichtungen mit Kontakten zu versehen.

15. Verfahren nach einem beliebigen der vorangehenden Ansprüche, wobei das Bereitstellen des plangemachten Photonik-Substrats auf Silizium-Basis das Bereitstellen von Dummy-Strukturen auf dem Photonik-Substrat auf Silizium-Basis und das Planmachen des Photonik-Substrats auf Silizium-Basis durch CMP umfasst und wobei die Dummy-Strukturen als eine Saatschicht für Ge-Wachstum eingesetzt werden, wodurch Dummy-Strukturen auf Ge-Basis erzeugt werden, was ein gutes Planmachen der Ge-Schicht mittels CMP erlaubt.

## Revendications

1. Procédé pour la co-intégration de dispositifs photoniques, photodétecteurs au Ge à guide d'ondes intégré et de lasers hybrides III-V/Si sur une plate-forme de photonique à base de silicium, le procédé comprenant :
- la fourniture d'un substrat photonique aplani à base de silicium comprenant des dispositifs au silicium incluant des structures de guide d'ondes à motifs de silicium (2) ;
- le dépôt d'une couche diélectrique (6) sur le dessus du substrat photonique aplani à base de silicium ;
- la gravure de tranchées (7) dans ladite couche diélectrique (6) avec une profondeur de gravure appropriée, exposant de ce fait une structure de guide d'ondes à motifs de silicium (2) dudit substrat photonique à un emplacement où la croissance de Ge pour former un photodétecteur au Ge doit être amorcée ;
- l'étape de gravure de tranchées étant suivie par une étape de gravure sélective de la structure de guide d'ondes exposée (2), créant de ce fait une matrice pour la croissance de Ge et laissant une couche d'ensemencement de silicium pour la croissance de Ge ;
- la culture sélective de Ge à partir de ladite couche d'ensemencement, avec une croissance excessive de Ge délibérée ;
- l'aplanissement de la surface de Ge, laissant une couche de Ge avec une épaisseur réduite.

2. Procédé selon la revendication 1, dans lequel la gravure sélective de la structure de guide d'ondes exposée comprend la gravure à une profondeur dans la plage entre 70 nm et 150 nm.

3. Procédé selon la revendication 1 ou 2, comprenant en outre un recuit de post-croissance pour réduire la densité de défauts dans la couche de Ge, avant l'aplanissement de ladite surface de Ge.

4. Procédé selon la revendication 1 à 3, dans lequel ladite couche de Ge avec une épaisseur réduite a une épaisseur entre 100 et 500 nm.

5. Procédé selon la revendication 1 à 4, dans lequel l'aplanissement de ladite surface de Ge comprend un processus de CMP.

6. Procédé selon n'importe laquelle des revendications précédentes, comprenant en outre le traitement d'un photodétecteur au Ge.

7. Procédé selon n'importe laquelle des revendications précédentes, comprenant en outre la réalisation de contacts métalliques sur le photodétecteur au Ge à une certaine distance de la région active de façon optique, de sorte que des pertes d'absorption au niveau des contacts sont limitées au-dessous d'un seuil prédéterminé.

8. Procédé selon n'importe laquelle des revendications précédentes, comprenant en outre la sélection de la matrice pour la croissance de Ge de sorte qu'une couche de Ge à nervure inversée, par exemple en forme de T, est obtenue.

9. Procédé selon la revendication 8, dans lequel ladite nervure inversée comprend une région active de façon optique de 250 nm à 300 nm d'épaisseur avec des parties en surplomb latéral plus minces sur lesquelles on peut réaliser des contacts métalliques.

10. Procédé selon n'importe laquelle des revendications précédentes, dans lequel la matrice pour la croissance de Ge est sélectionné de sorte qu'une couche de Ge à excroissance latérale, par exemple en forme de L, est obtenue, dans laquelle la région active de façon optique dans le Ge est formée par une excroissance latérale sur un guide d'ondes de silicium.

11. Procédé selon la revendication 10, dans lequel la matrice pour la croissance de Ge est sélectionnée de sorte que la région active de façon optique du Ge est latéralement disposée par rapport à, par exemple est à une certaine distance latérale de, la couche d'ensemencement, et ainsi à une distance latérale suffisamment grande des défauts près de la couche d'ensemencement, afin de réduire un courant d'obscurité au-dessous d'un seuil prédéterminé.

12. Procédé selon n'importe laquelle des revendications précédentes, comprenant en outre la liaison de couches III-V au substrat pour l'intégration de lasers hybrides III-V/silicium.

13. Procédé selon la revendication 12, dans lequel lesdites couches III-V sont disposées à une certaine distance verticale d'une structure de guide d'ondes de silicium dudit substrat photonique qui est plus petite que 100 nm.

14. Procédé selon n'importe laquelle des revendications 12 ou 13, comprenant en outre l'exécution d'un processus unique commun sur une unité de fabrication finale pour mettre en contact les lasers hybrides III-V/silicium, les photodétecteurs au Ge et les dispositifs au silicium.

15. Procédé selon n'importe laquelle des revendications précédentes, dans lequel la réalisation dudit substrat photonique aplani à base de silicium comprend la réalisation de structures factices sur ledit substrat photonique à base de silicium et l'aplanissement dudit substrat photonique à base de silicium par CMP, et dans lequel lesdites structures factices sont utilisées comme une couche d'ensemencement pour la croissance de Ge, créant de ce fait des structures factices à base de Ge permettant un bon aplanissement de la couche de Ge au moyen de CMP.
